# EUROPÄISCHE PATENTSCHRIFT

(11) **EP 0 558 903 B1**
(45) Veröffentlichungstag und Bekanntmachung des Hinweises auf die Patenterteilung: **02.04.1997**
(21) Anmeldenummer: 93100860.1
(22) Anmeldetag: 21.01.1993
(51) Int. Cl.: H04H 1/00

(54) **Autoradio mit einem RDS-Decoder**
Car radio with an RDS decoder
Autoradio avec décodeur RDS

(30) Priorität: 02.03.1992 DE 4206475
(43) Veröffentlichungstag der Anmeldung: 08.09.1993
(73) Patentinhaber: Blaupunkt-Werke GmbH, D-31132 Hildesheim (DE)
(72) Erfinder: Liman, Helmut, W-3204 Nordstemmen (DE); Trinks, Rüdiger, W-3384 Liebenburg 1 (DE); Lauke, Volker, W-3200 Hildesheim (DE)

(56) Entgegenhaltungen:
- EP-A- 0 364 749
- DE-A- 3 938 457
- DE-A- 3 942 339

## Beschreibung

Gegenstand des Schutzrechtes ist ein neues Autoradio mit einem RDS-Decoder und mit einer Sendersuchlaufautomatik zum Aufsuchen alternativer Frequenzen.

Es ist bekannt, in Autoradios mit einem RDS-Decoder einen Suchlauf nach einem neuen Sender in derselben Senderkette zu starten, wenn die Feldstärke des empfangenen Senders zu gering wird oder sich Mehrwegeempfang störend bemerkbar macht oder sich die RDS-Fehlerrate erhöht. Verschiedene Sender einer Senderkette werden auch als alternative Frequenzen bezeichnet, die in dem Signal des empfangenen Senders mit übertragen werden. Ein derartiger Empfänger wird zum Beispiel in der EP-A-0 364 748 beschrieben.

Die eben genannten Größen werden in bekannter Weise gemessen und die beiden zuletzt erwähnten Meßwerte sodann addiert, während der Feldstärkemeßwert davon subtrahiert wird. Überschreitet das Summensignal einen vorgegebenen Schwellwert, dann wird ein neuer Suchlauf ausgelöst.

Bei dieser Vorgehensweise ergeben sich Probleme, wenn das Autoradio mit dem Fahrzeug im grenzüberschreitenden Verkehr benutzt wird. Denn während in Deutschland der Hub des RDS-Signals 1,2 kHz beträgt, wird der Träger in Frankreich mit 4 kHz Hub moduliert. In Schweden läßt sich auch mit einer wesentlich geringeren Feldstärke noch ein guter Empfang realisieren, da dort der Funkstörnebel zum Beispiel erheblich geringer ist als in Mitteleuropa.

Die Erfinder suchten nach einer Lösung, diesen sich ändernden Voraussetzungen bei einem grenzüberschreitenden oder grenznahen Verkehr Rechnung zu tragen, so daß die Fehlfunktion der bekannten Schaltungen vermieden werden oder auf die Entwicklung länderspezifischer Autoradiotypen verzichtet werden kann.

Diese Aufgabe wird durch die Merkmale des Anspruchs 1 gelöst.

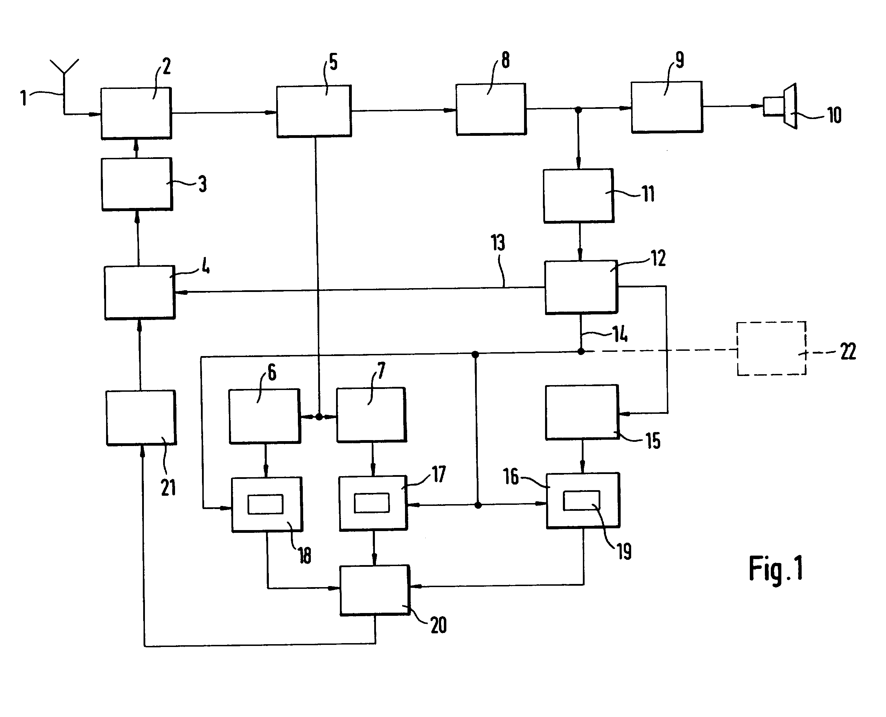

In der Zeichnung ist ein Blockschaltbild des neuen Autoradios dargestellt, das im folgenden näher erläutert wird.

Über die Antenne 1 wird der Träger des im Tuner 2 eingestellten Senders empfangen. Der Sender ist durch Veränderung der Frequenz des Mischoszillators 3 wählbar. Diese Frequenz ist u. a. durch eine Suchlaufautomatik 4 derart beeinflußbar, daß bei der Auslösung eines Suchlaufs nur ein anderer Sender derselben Senderkette aufgesucht wird. Das Auffinden von alternativen Frequenzen gehört zum Stand der Technik und ist hier nicht näher erläutert.

Vom Ausgang des Tuners 2 wird der in die ZF-Lage umgesetzte Träger des Senders dem Eingang der ZF-Stufe 5 zugeführt. Aus dem ZF-Signal wird in bekannter Weise in einer ersten Meßschaltung 6 eine von der Feldstärke abhängige Meßgröße und in der Meßschaltung 7 eine von Störungen des Signals durch Mehrwegeempfang abhängige Meßgröße gewonnen.

Die Modulation des Senders wird im Demodulator 8 von dem zwischenfrequenten Träger befreit und die NF-Komponente im NF-Verstärker 9 zur Wiedergabe über den Lautsprecher 10 ausreichend verstärkt.

An den Ausgang des Demodulators e ist über ein 57-kHz-Filter 11 ein RDS-Decoder 12 angeschlossen. An einem Ausgang 13 des RDS-Decoders 12 sind die alternativen Frequenzen des eingestellten Senders abgreifbar; diese werden in bekannter Weise in der Suchlaufautomatik 4 zwischengespeichert.

An einem zweiten Ausgang 14 steht neben der Senderkettenkennung auch die RDS-Länderkennung des empfangenen Senders zu weiteren Steuerzwecken zur Verfügung.

In einer an einen dritten Ausgang des RDS-Decoders angeschlossenen Schaltung 15 läßt sich ein Signal über die momentane Fehlerrate bei der Decodierung der RDS-Signale abnehmen.

Dem Ausgang dieser Schaltung 15 wie auch den Ausgängen der beiden Meßschaltungen 6 und 7 sind Modifikationsschaltungen 16, 17, 18 nachgeschaltet. Alle Modifikationsschaltungen sind gleichartig aufgebaut und enthalten Speicher 19, in denen den einzelnen Länderkennungen Multiplikatoren zugordnet sind. Diese Multiplikatoren modifizieren die Ausgangssignale der Meßstufen 6, 7 und 15. Die derart modifizierten Ausgangssignale werden danach in einer Summierstufe 20 addiert. An den Ausgang der Summierstufe 20 ist ein Schwellwertschalter 21 angeschlossen, der seinerseits mit dem Starteingang der Suchlaufautomatik 4 verbunden ist.

In einem gestrichelt angedeuteten zweiten Ausführungsbeispiel ist parallel zum Ausgang 14 des RDS-Decoders der Ausgang einer manuellen Eingabeschaltung 22 für die Länderkennung an die Eingänge der Speicher 19 angeschlossen. Die jeweiligen Ausgänge sind, was nicht näher dargestellt ist, in geeigneter Weise voneinander entkoppelt. Die manuelle Eingabeeinheit kann in einem neuen Autoradio auch allein zur Eingabe der Länderkennung vorgesehen sein.

Fährt ein Fahrer mit einem derart beschaffenen Autoradio in der Nähe einer Grenze, so ist er in der Lage, Sender von beiden Seiten der Grenze zu empfangen, darunter auch RDS-Sender, die in ihrem RDS-Telegramm darüber Auskunft geben, zu welcher Senderkette sie gehören und in welchem Land diese Senderkette betrieben wird. Diese Länderkennung wird nun in dem neuen Autoradio decodiert und steht während der Empfangszeit des bestimmten Senders am Ausgang 14 des RDS-Decoders zur Verfügung.

In dem Speicher 19 jeder der Modifikationsschaltungen 16, 17, 18 ist bei der Herstellung des Gerätes eine Zuordnungstabelle eingelesen, die für jedes Land festlegt, mit welchem Gewicht die jeweilige Meßgröße über die Feldstärke, den Mehrwegeempfang und die RDS-Fehlerrate bei der Aufsummierung eingehen soll.

Bei dem Empfang im fahrenden Auto können sich diese Größen unabhängig voneinander ändern, obwohl zwischen der Feldstärke und der Fehlerrate bzw. dem Mehrwegeempfang und der Fehlerrate gewisse Abhängigkeiten bestehen. In diese Abhängigkeiten geht aber ersichtlich auch die Größe des Hubes ein, mit dem das RDS-Datentelegramm vom Sender übertragen wird.

Übersteigt nun das Summensignal am Ausgang der Summierstufe 20 einen im Schwellwertschalter 21 zuvor festgelegten Wert, dann wird über den Starteingang der Suchlaufautomatik 4 ein Suchlauf nach einem anderen Sender derselben Senderkette gestartet.

Findet das Autoradio jedoch keinen besseren Sender, dann wird der Fahrer von sich aus eine neue Senderkette einschalten, welche durchaus in dem anderen der beiden aneinander angrenzenden Länder liegen kann. Es ist also nicht erforderlich, daß das Fahrzeug zum Wirksamwerden der Merkmale des neuen Autoradios selbst die Grenze überschreitet.

Es ist im Rahmen der Erfindung nicht ausgeschlossen, statt einer Länderkennung die Senderkennung einzusetzen, wenn sich ergeben sollte, daß die Senderketten allein über den RDS-Modulationsgrad ihrer Träger entscheiden können, wenn im Rahmen der Vorschriften keine Pflichtwerte, sondern nur Obergrenzen dafür vorgegeben werden.

## Patentansprüche

1. Autoradio mit einem RDS-Decoder (12) und mit einer Sendersuchlaufautomatik (4) zum Aufsuchen alternativer Frequenzen einer eingestellten Senderkette, mit Meßschaltungen (6, 7, 15) für die Feldstärke, für die Störungen durch Mehrwegeempfang und für die RDS-Fehlerrate, und mit einer Summierstufe (20) für die Meßsignale, die über einen Schwellwertschalter (21) einen Suchlauf auslöst,
gekennzeichnet durch
Modifikationsschaltungen (16, 16, 17, 18), die den Ausgängen der einzelnen Meßschaltungen (6, 7, 15) nachgeschaltet sind und Speicher (19) umfassen, die an den Ausgang (14) des RDS-Decoders (12) angeschlossen sind und die in Abhängigkeit von an dem Ausgang (14) abgreifbaren Kennungen zugeordnete Multiplikatoren für die jeweilige Modifikationsschaltung aktivieren.

2. Autoradio nach Anspruch 1,
dadurch gekennzeichnet,
daß die Kennungen wahlweise auch über eine manuelle Eingabeschaltung (22) eingebbar sind.

3. Autoradio nach Anspruch 1,
dadurch gekennzeichnet,
daß als Kennung die Länderkennung aus dem RDS-Datentelegramm ausgewählt wird.

## Claims

1. Car radio with an RDS decoder (12) and with an automatic transmitter search run device (4) for searching for alternative frequencies of a transmitter group which has been set, with measuring circuits (6, 7, 15) for the field strength, for the interference as a result of multipath reception and for the RDS error rate, and with a summing stage (20) for the measuring signals, which summing stage (20) triggers a search run by means of a threshold value switch (21), characterized by modification circuits (16, 17, 18) which are connected downstream of the outputs of the individual measuring circuits (6, 7, 15) and comprise memories (19) which are connected to the output (14) of the RDS decoder (12) and which activate multipliers, assigned as a function of codes which can be picked off at the output (14), for the respective modification circuit.

2. Car radio according to Claim 1, characterized in that the codes can also be optionally input via a manual input circuit (22).

3. Car radio according to Claim 1, characterized in that the Federal State code from the RDS data telegram is selected as code.

## Revendications

1. Autoradio à décodeur RDS (12) et automatisme de recherche d'émetteur (4) pour rechercher les fréquences alternatives d'une ligne d'émetteurs réglée, comprenant des circuits de mesure (6, 7, 15) de l'intensité du champ, des parasites par réception par chemins multiples et du taux de défauts RDS ainsi qu'un étage additionneur (20) pour les signaux de mesure déclenchant une recherche par l'intermédiaire d'un interrupteur à seuil (21),
caractérisé par
des circuits de modification (16, 17, 18) en aval des sorties des différents circuits de mesure (6, 7, 15) et comprenant des mémoires (19) reliées à la sortie (14) du décodeur SDS (12) et activées en fonction de multiplicateurs associés aux caractéristiques fournies à la sortie (14) pour chacun des circuits de modification.

2. Autoradio selon la revendication 1,
caractérisé en ce que
les caractéristiques peuvent être introduites au choix par un circuit d'entrée manuel (22).

3. Autoradio selon la revendication 1,
caractérisé en ce que
la caractéristique des pays est sélectionnée à partir du télégramme de données RDS.
